(19) Europäisches Patentamt
European Patent Office
Office européen des brevets

(11) **EP 3 999 863 B1**

(12) **FASCICULE DE BREVET EUROPEEN**

(45) Date de publication et mention de la délivrance du brevet:
**26.06.2024 Bulletin 2024/26**

(21) Numéro de dépôt: **20750711.2**

(22) Date de dépôt: **13.07.2020**

(51) Classification Internationale des Brevets (IPC):
**G01R 31/378** [(2019.01)] **G01R 31/3842** [(2019.01)]

(52) Classification Coopérative des Brevets (CPC):
**G01R 31/378; G01R 31/3842**

(86) Numéro de dépôt international:
**PCT/FR2020/051263**

(87) Numéro de publication internationale:
**WO 2021/014072 (28.01.2021 Gazette 2021/04)**

(54) **ESTIMATION DU SOC D'UN ELÉMENT ELECTROCHIMIQUE**

SCHÄTZUNG DES SOC EINES ELEKTROCHEMISCHEN ELEMENTS

ESTIMATION OF THE SOC OF AN ELECTROCHEMICAL ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.07.2019 FR 1908261**

(43) Date de publication de la demande:
**25.05.2022 Bulletin 2022/21**

(73) Titulaire: **SAFT**
**92300 Levallois-Perret (FR)**

(72) Inventeurs:
• **TEUTSCH, François**
**33650 St Médard d'Eyrans (FR)**
• **GUILLONNEAU, Erwan**
**33320 Eysines (FR)**

(74) Mandataire: **Bandpay & Greuter**
**11 rue Christophe Colomb**
**75008 Paris (FR)**

(56) Documents cités:
**EP-A1- 3 182 552 DE-A1-102012 206 893**
**US-A1- 2016 211 679**

**Description**

**DOMAINE DE L'INVENTION**

La présente invention concerne le domaine technique des méthodes, systèmes et programmes d'estimation de charge (SoC) d'un élément électrochimique pour lequel une mesure de la tension ne permet pas d'estimer en permanence avec précision son état de charge.

**ARRIERE-PLAN TECHNIQUE**

Un générateur électrochimique ou accumulateur ou élément est un dispositif de production d'électricité dans lequel de l'énergie chimique est convertie en énergie électrique. L'énergie chimique est constituée par des composés électrochimiquement actifs disposés dans l'élément. L'énergie électrique est produite par des réactions électrochimiques au cours d'une décharge de l'élément. Les électrodes, disposées dans un contenant, sont connectées électriquement à des bornes de sortie de courant qui assurent une continuité électrique entre les électrodes et un consommateur électrique auquel l'élément est associé.

Typiquement, une batterie comprend une pluralité d'éléments susceptibles d'être regroupés au sein d'une même enceinte. Une batterie peut être divisée en modules, chaque module étant composé d'une pluralité d'éléments reliés entre eux en série et/ou en parallèle. La batterie est destinée à fournir de l'énergie électrique à une application extérieure. Un circuit de charge est généralement prévu auquel la batterie peut être branchée pour recharger les éléments. Un système de gestion comprenant des capteurs de mesures et un circuit électronique de contrôle, plus ou moins évolué selon les applications, peut être associé à la batterie.

Il est connu des standards de calcul de l'état de charge (SoC, acronyme anglais de « State Of Charge ») d'un élément et par extension d'une batterie. Le SoC est la quantité d'énergie disponible dans la batterie rapportée à l'énergie d'une batterie totalement chargée. Typiquement il s'exprime en pourcentage et reflète la part d'énergie restante disponible pour l'utilisateur. Aujourd'hui, la plupart des standards de calcul du SoC sont basés sur une mesure continue des données tension-courant-température. Par exemple, on peut utiliser les deux modes de calculs suivants qui s'alternent successivement. Le mode principal est coulométrique, c'est-à-dire que l'état de charge dépend directement du comptage des Ampères-heures et de la capacité de la batterie. Or, ce mode est très sensible à l'erreur de mesure en courant ainsi qu'à l'estimation de la capacité. Des dérives en tension peuvent se produire si ce mode est utilisé seul. Le second mode est généralement basé sur la mesure en tension et utilise une table de l'état de charge en fonction de la tension en circuit ouvert. Mais ce second mode est sensible à l'estimation de la résistance, et une erreur d'estimation de résistance entraînera une erreur d'estimation de la tension en circuit ouvert (OCV, acronyme anglais de « Open Circuit Voltage ») et donc une erreur d'estimation du SoC.

Il est également connu des éléments dont la technologie est caractérisée par une courbe d'OCV fonction du SoC qui présente une pente faible car elle possède au moins une zone où la variation de l'OCV en fonction du SoC varie peu et/ou peut être non-univoque ; il est impossible d'associer une mesure de tension à un état de charge. La courbe d'OCV fonction du SoC peut être non-univoque, c'est-à-dire qu'il existe deux points de la courbe qui ont la même ordonnée mais une abscisse différente. Le document EP-A-2 269 954 décrit des exemples de tels éléments pour lesquels la variation de la tension à vide en fonction de l'état de charge présente une zone pour un état de charge compris entre environ 30 et environ 90% dans laquelle la tension à vide augmente au moins 10 fois moins rapidement en fonction de l'état de charge en moyenne que pour un état de charge compris entre 90% et 100%. De tels éléments sont connus sous le nom d'éléments électrochimiques à profil plat ou plus simplement éléments à profil plat. Le vieillissement induira des modifications de la relation entre l'OCV et le SoC.

Pour de tels éléments à profil plat, dans les zones où la croissance de la courbe d'OCV fonction du SoC est lente, il n'est pas possible de calibrer le SoC sur la tension, l'incertitude sur la mesure étant trop importante. Le calcul du SoC y est donc purement coulométrique. Il est connu que l'information d'état de charge fournie est suffisamment précise pour une partie (appelée zone 4) de la courbe d'OCV fonction du SoC correspondant à un SoC compris aux alentours de 90 à 100%. Quand bien même la capacité serait bien estimée, l'erreur sur la mesure en courant limiterait le nombre de cycles autorisé sans calibration dans cette zone 4. Les méthodes actuelles de gestion de tels éléments comprennent de recaler l'information de SoC sur la tension sur la zone 4, à faible courant afin de minimiser l'incertitude de la valeur de la résistance. Cela peut imposer pour certaines application une pleine charge régulière, ce qui n'est notamment pas adapté pour des applications hybrides comme le ferroviaire ou les bus où la contrainte est journalière. Il est également possible de recaler en Zone 1 de la courbe d'OCV fonction du SoC ; la zone 1 correspond à un SoC compris aux alentours de 0 à 30%. Mais cela implique d'avoir connaissance de l'erreur commise sur le SoC par coulométrie proche de la fin de décharge.

Le document US 2016/0211679 A1 décrit un dispositif de stockage d'énergie comprenant une batterie. Le document DE 10 2012 206 893 A1 décrit un procédé de détermination de l'état de charge d'une batterie. Le document EP 3 182 552 A1 décrit un système de gestion de batterie au lithium-soufre pour déterminer un état de charge d'une batterie au lithium-soufre.

Il n'existe donc pas actuellement de méthode susceptible d'être adaptée de manière satisfaisante à l'estimation de l'état de charge d'un élément électrochimique, et notamment lorsque l'élément électrochimique est un élément à profil plat.

**Résumé de l'invention**

La présente invention propose un procédé d'estimation de l'état de charge (SoC) d'un élément électrochimique. Le procédé d'estimation du SoC comprend

- une initiation d'une opération de charge ou de décharge de l'élément électrochimique qui est traversé par un courant ;
- pendant l'opération de charge ou de décharge de l'élément électrochimique :

-- une opération de charge ou une décharge d'un élément de stockage d'énergie qui est traversé par le même courant que l'élément électrochimique, l'élément de stockage d'énergie ayant une relation tension-niveau de charge qui est bijective pour au moins deux valeurs de la tension aux bornes de l'élément de stockage, la capacité $C_{ES}$ de l'élément de stockage représentant une partie de la capacité totale de l'élément électrochimique ;
-- une détection que l'élément de stockage est chargé ou déchargé ;
-- un calcul d'une nouvelle valeur de la capacité $C_N$ de l'élément électrochimique par la formule :

--- pour une opération de charge :

$$C_N = C_{N-1} + C_{ES} \ ;$$

--- pour une opération de décharge :

$$C_N = C_{N-1} - C_{ES} \ ;$$

où $C_{N-1}$ est une précédente valeur connue de la capacité de l'élément électrochimique;

- suite à la détection que l'élément de stockage est chargé ou déchargé, une inversion de polarité aux bornes de l'élément de stockage causant une décharge de l'élément de stockage si l'élément de stockage est chargé et une charge de l'élément de stockage si l'élément de stockage est déchargé, une itération de la charge ou décharge de l'élément de stockage, de la détection, et du calcul ;

Un tel procédé améliore l'estimation du SoC d'un élément électrochimique car elle repose sur des mesures fractionnées d'un composant de stockage d'énergie dont la capacité représente une fraction de la capacité totale de l'élément électrochimique à évaluer. Le SoC est évalué (ou encore estimé) sur des mesures fractionnées du SoC que le procédé va comptabiliser selon un contexte de courant traversant la batterie. L'estimation du SoC est indépendante de mesures électriques devant être effectuées directement ou indirectement aux bornes de l'élément électrochimique car elle se fait sur un élément de stockage qui est extérieur à l'élément électrochimique. L'élément de stockage possède une relation tension-niveau de charge qui est bijective pour au moins deux valeurs de la tension à ses bornes, ce qui permet d'obtenir au moins deux points de mesures d'une valeur de la charge de l'élément de stockage quel que soit le niveau de charge de l'élément électrochimique, et donc de l'élément électrochimique par simple comptage des charges et décharges successives de l'élément de stockage. Ainsi, l'estimation du SoC peut être effectuée quelle que soit l'intensité du courant sans perte de précision, et elle peut être effectuée avec une charge ou décharge partielle de l'élément sans imposer un cycle de maintenance. Le procédé permet ainsi d'autoriser les cyclages de longue durée sur les zones plateaux de l'élément électrochimique sans dérives du SoC liées à l'erreur sur la mesure en courant sur les zones plateaux.

Selon différents modes de réalisation, toute combinaison d'au moins l'une des caractéristiques suivantes peut être implémentée :

- l'inversion de polarité comprend un envoi d'une commande de configuration d'éléments de commutation d'une structure électronique de pont en H sur laquelle structure électronique l'élément de stockage est connecté ;

- la sélection d'une première commande de configuration des éléments de commutation après la détection que l'élément de stockage est chargé ; la sélection d'une deuxième commande de configuration des éléments de commutation après la détection que l'élément de stockage est déchargé ;
- comprenant en outre un calcul d'une première valeur de SoC de l'élément électrochimique par une première formule $SoC = SoC_{initial} + 100 * (C_N / C_T)$ où $C_T$ est la capacité maximale de l'élément électrochimique, $SoC_{initial}$ est une valeur de SoC obtenue avec la formule $SoC_{initial} = 100 * (C_{N-1} / C_T)$ où la précédente valeur connue $C_{N-1}$ est la capacité de l'élément électrochimique mesurée dans la partie bijective de la courbe SoC de l'élément électrochimique lors d'une initiation d'une opération de charge ou de décharge ;
- le calcul de la valeur de SoC de l'élément électrochimique comprend le calcul d'une deuxième formule $SoC = SoC_{initial} + 100 * (C_N / C_T) + \alpha * 100 * (C_{ES} / C_T)$ où $\alpha$ est une fraction de charge de l'élément de stockage à l'instant où la valeur de SoC est calculée ;
- successivement l'initiation d'au moins une opération de charge et d'au moins une opération de décharge de l'élément électrochimique, ou inversement l'initiation d'au moins une opération de décharge et d'au moins une opération de charge de l'élément électrochimique ;
- après le calcul de la nouvelle valeur de la capacité $C_N$, la mémorisation de la capacité $C_N$ comme étant une précédente valeur connue $C_{N-1}$ ;
- pendant la réalisation de l'opération de charge ou de décharge, une détection du sens du courant aux bornes de l'élément électrochimique, et la détermination qu'une opération de charge ou de décharge de l'élément électrochimique est réalisée selon le sens du courant détecté ;
- la détection que l'élément de stockage est chargé ou déchargé comprend une mesure d'une tension $V_C$ aux bornes de l'élément de stockage ; une détermination que l'élément de stockage est déchargé si la tension mesurée est sensiblement nulle ; une détermination que l'élément de stockage est chargé si la tension mesurée est sensiblement égale à une valeur de tension maximale connue ;
- après le calcul de la nouvelle valeur de la capacité $C_N$ : une mesure de tension $V_{Bat}$ de l'élément électrochimique ; si la tension $V_{Bat}$ mesurée est sensiblement égale à une tension minimale $V_{Bat\_Min}$ connue, la mise à zéro de la valeur de la précédente valeur connue $C_{N-1}$ ; si la tension $V_{Bat}$ mesurée est sensiblement égale à une tension maximale $V_{Bat\_Max}$ connue, la fixation de la précédente valeur connue $C_{N-1}$ à la valeur connue de la capacité total $C_T$ de l'élément électrochimique.

La présente invention propose également un programme d'ordinateur comprenant des instructions de code de programme pour l'exécution du procédé d'estimation de l'état de charge (SoC) d'un élément électrochimique.

La présente invention propose aussi un support d'information lisible par un ordinateur sur lequel est enregistré le programme d'ordinateur.

La présente invention propose en outre un système de mesure de l'état de charge (SoC) d'un élément électrochimique, comprenant un élément de stockage d'énergie ayant une relation tension-niveau de charge qui est bijective pour au moins deux valeurs de la tension aux bornes de l'élément de stockage et dont la capacité $C_{ES}$ représente une partie de la capacité totale de l'élément ; un détecteur de l'état de charge de l'élément de stockage d'énergie ; un inverseur de polarité connecté aux bornes de l'élément de stockage d'énergie ; une unité de calcul en communication avec le détecteur et l'inverseur, et couplée à une mémoire, la mémoire stockant un le programme d'ordinateur et étant apte à mémoriser au moins une précédente valeur connue de la capacité $C_{N-1}$ de l'élément électrochimique, une valeur connue de la capacité totale $C_T$ de l'élément électrochimique.

Selon différents modes de réalisation, toute combinaison avec le système d'au moins l'une des caractéristiques suivantes peut être implémentée :

- l'inverseur de polarité est une structure électronique de pont en H comprenant des éléments de commutation ; et comprenant en outre une unité de commande des éléments de commutation, l'unité de commande étant couplée au détecteur de l'état de charge de l'élément de stockage d'énergie et comprenant une bascule couplée au détecteur de l'état de charge de l'élément de stockage d'énergie, la bascule étant apte à recevoir au moins un premier signal et un deuxième signal provenant du détecteur de l'état de charge de l'élément de stockage d'énergie, le premier représentant une détection que l'élément de stockage est chargé et un deuxième signal du détecteur représentant une détection que l'élément de stockage est déchargé ; maintenir un premier état de sortie suite à la réception du premier signal et un deuxième état de sortie suite à la réception du deuxième signal ; des pilotes des éléments de commutation, les pilotes étant couplés à la bascule et aptes à recevoir le premier état de sortie et le deuxième état de sortie, configurer les éléments de commutation selon une première configuration sur réception du premier état de sortie et selon une deuxième configuration sur réception du deuxième état de sortie ;
- le détecteur de l'état de charge de l'élément de stockage d'énergie est en outre apte à recevoir une valeur d'une tension $V_C$ aux bornes de l'élément de stockage, le détecteur comprenant un premier comparateur de tension apte à déterminer que la tension $V_C$ est sensiblement nulle ; un deuxième comparateur de tension apte à déterminer que la tension $V_C$ est sensiblement égale à une valeur de tension maximale $V_{C\_Max}$ stockée dans la mémoire ;

- l'élément de stockage d'énergie est un supercondensateur ;
- un détecteur du sens du courant de l'élément électrochimique.

La présente invention propose en outre un ensemble comprenant le système de mesure du SoC, un élément électrochimique couplé avec le système de mesure du SoC.

Selon différents modes de réalisation, l'ensemble peut également comprendre :

- l'élément électrochimique est celui d'une batterie comprenant un ou plus éléments électrochimiques ;
- la batterie comprend deux ou plus branches, chaque branche comprenant un ou plusieurs éléments électrochimiques et étant couplée avec un système de mesure du SoC.

## BREVE DESCRIPTION DES FIGURES

Des modes de réalisation de l'invention vont être maintenant décrits au moyen d'exemples non-limitatifs de l'invention, et en référence aux figures, où :

Fig. 1 est un exemple d'élément électrochimique dont la courbe d'OCV en fonction du SoC comprend une zone plate ;
Fig. 2 est un exemple de système selon l'invention ;
Fig. 3 est un exemple de variation du SoC de l'élément électrochimique en relation avec les charges et décharges de l'élément de stockage ;
Fig. 4 est un exemple d'algorigramme de l'invention ;
Fig. 5 est un exemple de batterie ; et
Fig. 6 est un exemple de système pour estimer le SoC.

## DESCRIPTION DE MODES DE REALISATION DE L'INVENTION

La présente invention concerne l'estimation de l'état de charge (SoC) d'un générateur électrochimique, aussi connu sous le terme d'accumulateur ou élément électrochimique ou encore élément. Ces termes désignent un dispositif de production d'électricité dans lequel de l'énergie chimique est convertie en énergie électrique et sont considérés comme synonymes par la suite.

On entend par tension en circuit ouvert (ou encore tension à vide) la tension mesurée aux bornes de l'élément lorsque celui-ci ne débite aucun courant (« Open circuit voltage » en anglais et également dénommé « tension en circuit ouvert » ; selon la définition 482-03-32 de la norme CEI 60050-482 :2004, Vocabulaire électrotechnique international partie 482 : piles et accumulateurs électriques).

On entend par courbe d'OCV en fonction du SoC, la variation de la tension en fonction de l'état de charge, dit plus simplement, la courbe d'OCV en fonction du SoC est une table qui met en relation des points de mesure d'OCV en fonction de valeurs de SoC.

La présente invention peut s'appliquer à un type particulier d'élément électrochimique dont la courbe d'OCV en fonction du SoC comprend soit une partie de courbe à faible pente, et/ou une partie de courbe à pente nulle, et/ou une partie de courbe qui n'est pas univoque. Ce type d'élément électrochimique est également connu sous l'expression « élément électrochimique à profil plat » ou plus simplement « élément à profil plat » ; le profil plat correspondant donc à la partie de courbe présentant la faible pente, et/ou la partie de courbe présentant la pente nulle, et/ou la partie de courbe qui n'est pas univoque. Plus généralement, un élément électrochimique à profil plat est un élément électrochimique dont au moins une partie de la variation de la tension OCV est comprise dans l'erreur de mesure du capteur servant à mesurer et/ou à estimer l'OCV, et/ou une partie de la courbe n'est pas univoque.

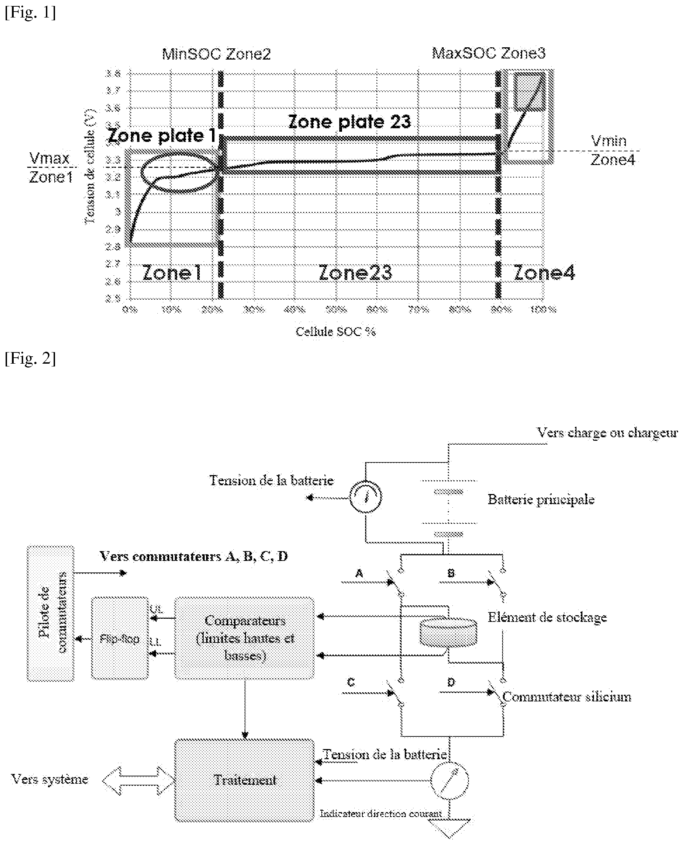

La Fig. 1 est un exemple schématique d'une courbe d'OCV fonction du SoC qui compte au moins un profil plat. Dans cet exemple, l'élément est un élément Lithiumion dont une électrode positive comprend une matière électrochimiquement active de type phosphate lithié ou du type de celle décrite dans le document EP-A-2 269 954. Dans l'exemple de la Fig. 1, la courbe peut être divisée en quatre zones. La précision de mesure implique que les zones 2 et 3 sont confondues et forment un seul et même plateau ou zone plate (zone 23). La courbe d'OCV fonction du SoC de la zone 23 peut être non-univoque, c'est-à-dire qu'il existe deux points de la courbe qui ont la même ordonnée (une même valeur d'OCV) mais une abscisse différente (au moins deux valeurs de SoC différentes). La zone 1 dispose également d'un plateau, ce qui réduit fortement la zone pentue où une calibration sur la tension est possible. Le plateau de la zone 1 est la partie de la courbe qui est entourée sur la Fig. 1 ; en outre, cette zone 1 peut être la plus impactée par le vieillissement de l'élément. La zone 4 est la zone qui comprend une pente suffisante pour permettre une mesure précise de l'information de l'état de charge.

Les trois zones principales représentées sur la Fig. 1 sont maintenant discutées plus en détail. Zone 1 : elle correspond à une tension inférieure ou égale à VmaxZonel. A la valeur VmaxZonel correspond un état de charge égal à MinSoCZone2. VmaxZonel se situe en général entre 3 et 3,30V et vaut typiquement 3,30V. MinSoCZone2 se situe généralement dans la gamme allant de 15 à 30%, typiquement 30%. Dans la zone 1, la tension varie quasiment proportionnellement avec l'état de charge ; c'est-à-dire qu'à une tension donnée de l'élément correspond un état de charge donné. La zone 1 se subdivise encore en une première zone d'état de charge comprise entre 0 et moins de 10%, dans laquelle la tension de l'élément varie de plus 300 mV et une seconde zone d'état de charge comprise entre typiquement 10% et typiquement 30%, dans laquelle la tension varie moins vite en fonction de l'état de charge, par exemple d'environ 100 mV pour un accroissement d'état de charge de 20%. Cette seconde zone de charge est la partie de la courbe qui est entourée sur la Fig. 1.

Zone 23 : elle correspond à une tension supérieure à VmaxZonel et inférieure à VminZone4. VminZone4 se situe en général entre 3,35 et 3,45V, et vaut typiquement 3,40V. A la valeur VminZone4 correspond un état de charge égal à MaxSoCZone3. MaxSoCZone3 se situe généralement dans la gamme allant de 80 à 95%, typiquement 90%. La zone 23 correspond typiquement à la zone de tensions comprises entre 3,30 V et 3,40 V correspondant à un état de charge compris typiquement entre 20% et typiquement 90 %. On peut noter une variation de tension de l'élément quasi nulle pour un état de charge compris entre 30% et 60% et pour un état de charge compris entre 65% et 90%. Dans la zone 23, la tension de l'élément varie peu, typiquement de l'ordre de 100 mV pour un état de charge compris entre environ 30 et environ 90%. Il en résulte une forte imprécision de l'état de charge dans la zone 23 puisqu'une valeur donnée de tension peut correspondre à un état de charge compris dans une large plage allant de 30 à 90%. La zone 23 se subdivise en deux sous-zones ; une première sous-zone : la zone 2 allant de MinSoCZone2 à MaxSoCZone2, soit de 22 à 60% et une seconde sous-zone, la zone 3 allant de MinSoCZone3 à MaxSoCZone3, soit de 65 à 90%. Les zones 2 et 3 se rejoignent vers un état de charge compris entre 60 et 65%.

Zone 4 : elle correspond à une tension supérieure ou égale à VminZone4. A la valeur VminZone4 correspond un état de charge égal à MaxSoCZone3. VminZone4 correspond à un état de charge d'environ 90%. Dans cette zone, la tension varie proportionnellement avec l'état de charge. Elle varie d'environ au moins 300 mV. A une tension donnée de l'élément correspond un état de charge donné.

L'exemple de la Fig. 1 n'est pas limitatif en ce sens qu'il n'illustre qu'un exemple d'élément à profil plat. De manière générale, un élément à profil plat est un élément électrochimique dont la matière active positive présente un profil de charge dans lequel la variation de la tension en fonction de l'état de charge entre un état de charge supérieur à MinSoCzone2 correspondant à une tension VmaxZone1 prédéterminée et un état de charge inférieur à MaxSoCzone3 correspondant à une tension VminZone4. La valeur de la tension OCV varie entre VmaxZonel et VmaxZone2 et cette variation est comprise dans l'erreur de mesure d'un capteur de tension ; par exemple la précision du capteur n'est pas suffisante pour mesurer les variations d'OCV en zone 23.

Il est maintenant discuté des exemples d'estimation de l'état de charge (SoC) d'un élément électrochimique.

Dans une première étape, une opération de charge ou une opération de décharge de l'élément électrochimique est initiée. L'opération de charge ou de décharge de l'élément électrochimique est ensuite exécutée pour une durée qui dépend des conditions d'utilisation de l'élément électrochimique.

Pendant que l'opération de charge ou de décharge précédemment initiée se déroule, une opération de charge ou une décharge d'un élément de stockage d'énergie est réalisée. L'élément de stockage d'énergie est également nommé élément de stockage par la suite. Si l'élément électrochimique est en charge, l'élément de stockage peut être en charge ou en décharge ; inversement, si l'élément électrochimique est en décharge, l'élément de stockage peut être en charge ou en décharge.

Lors d'une charge ou une décharge de l'élément de stockage, ce dernier est traversé par le même courant que l'élément électrochimique. Cela veut dire que le courant a une même valeur ou encore une valeur sensiblement identique, de petites variations de valeurs pouvant intervenir, par exemple à cause de pertes.

L'élément de stockage d'énergie a une relation tension-niveau de charge qui est bijective, et ce pour au moins deux valeurs de la tension aux bornes de l'élément de stockage. Cela veut donc dire qu'il est possible de connaitre l'état de charge de l'élément de stockage pour deux valeurs de tensions.

Dans des exemples, une première valeur de tension pour relation tension-niveau de charge qui est bijective est une valeur de tension nulle ou sensiblement nulle $V_0$ de l'élément de stockage, une deuxième valeur de tension pour relation tension-niveau de charge qui est bijective est une valeur de tension maximale ou sensiblement maximale $V_{MAX}$ de l'élément de stockage. Cette première valeur $V_0$ de tension correspond à la valeur de tension pour laquelle l'élément de stockage est déchargé (ou encore en état déchargé), et la deuxième valeur de tension $V_{MAX}$ correspond à la valeur de tension pour laquelle l'élément de stockage est chargé (ou encore en état chargé). Il est bien connu qu'en état chargé, le courant qui traverse l'élément de stockage est nul.

Dans des exemples, l'élément de stockage peut être un condensateur. Dans un exemple, le condensateur est un condensateur électrolytique.

Dans des exemples, l'élément de stockage peut être une supercondensateur. Une supercondensateur est un condensateur de technique permettant d'obtenir une densité de puissance et une densité d'énergie intermédiaire entre celle de batteries et des condensateurs classiques, par exemple un condensateur électrolytique.

La capacité de l'élément de stockage représente une partie de la capacité totale de l'élément électrochimique. Une partie de la capacité totale de l'élément électrochimique signifie une fraction de la capacité totale de l'élément électrochimique. Par exemple, cette fraction peut être, mais n'est pas limitée à, 1/10, 1/25, 1/50, 1/100, 1/1000, 1/10000... de la capacité totale de l'élément électrochimique.

Dans des exemples, la capacité totale de l'élément électrochimique peut être la capacité totale théorique de l'élément électrochimique.

Dans des exemples, la capacité totale de l'élément électrochimique peut être la capacité totale mesurée de l'élément électrochimique pour une ou des premières opérations de charge ou de décharge de l'élément électrochimique. « Une des premières opérations » peut être une opération de charge ou de décharge par rapport à un état initial de l'élément électrochimique. L'état initial peut être celui d'un élément neuf, ou d'un élément déjà vieillit (c'est-à-dire usagé), ou d'un élément de seconde vie (c'est-à-dire pour une nouvelle utilisation).

Toujours pendant que l'opération de charge ou de décharge précédemment initiée se déroule, on détecte que l'élément de stockage est chargé ou déchargé. Il est équivalant de dire que l'élément de stockage est complètement chargé, ou encore que l'élément de stockage est sensiblement chargé ; dans tous les cas, on considère que l'élément de stockage est chargé lorsqu'il ne peut plus accumuler d'énergie. Similairement, il est équivalant de dire que l'élément de stockage est complètement déchargé, ou encore que l'élément de stockage est sensiblement déchargé ; dans tous les cas, on considère que l'élément de stockage est déchargé lorsqu'aucune énergie n'y est stockée. La détection que l'élément de stockage est chargé ou déchargé peut être réalisée à l'aide de techniques habituelles. Des exemples sont présentés ci- après.

Suite à la détection que l'élément de stockage est chargé ou déchargé, une nouvelle valeur de la capacité de l'élément électrochimique est calculée. Cette nouvelle capacité est notée $C_N$. $C_N$ représente la quantité d'énergie qui est stockée dans l'élément électrochimique. Le calcul utilise une précédente valeur connue de la capacité de l'élément électrochimique. Cette précédente valeur est notée $C_{N-1}$. $C_{N-1}$ représente la quantité d'énergie qui était précédemment stockée dans l'élément électrochimique avant que ne soit détecté que l'élément de stockage est chargé ou bien déchargé.

Lorsqu'une opération de charge de l'élément électrochimique est réalisée, l'opération de charge étant réalisée au moins au moment où il a été détecté que l'élément de stockage est chargé ou déchargé, la nouvelle capacité $C_N$ est calculée par la formule (eq. 1)

$$C_N = C_{N-1} + C_{ES} \quad (\text{eq. 1})$$

Lorsqu'une opération de décharge de l'élément électrochimique est réalisée, l'opération de décharge étant réalisée au moins au moment où il a été détecté que l'élément de stockage est chargé ou déchargé, la nouvelle capacité $C_N$ est calculée par la formule (eq. 2)

$$C_N = C_{N-1} - C_{ES} \quad (\text{eq. 2}).$$

Ainsi, les formules (eq. 1) et (eq. 2) permettent de connaitre la quantité d'énergie stockée dans l'élément électrochimique à un moment donné en utilisant une fraction de la capacité effective de l'élément électrochimique qui est donnée par la détection que l'élément de stockage est chargé ou bien déchargé. On comprend donc que l'élément de stockage sert à mesurer une quantité d'énergie qui a été apportée ou bien retirée de l'élément de stockage.

L'élément de stockage peut être recalibré dynamique en fonction de son propre vieillissement. Ainsi, la précision des résultats donnés par les formules (eq. 1) et (eq. 2) est améliorée puisque la capacité réelle de l'élément de stockage est connue.

Dans des exemples, on peut calculer successivement une ou plusieurs nouvelles nouvelle capacité $C_N$ selon la méthode présentée ci-dessus. Chaque itération comprend donc successivement une opération de charge ou de décharge de l'élément de stockage, la détection que l'élément de stockage est déchargé ou chargé, le calcul de la nouvelle capacité $C_N$.

Chaque itération comprenant une opération de charge ou de décharge de l'élément de stockage, cela implique que l'élément de stockage doit être électriquement apte à réaliser une opération de charge s'il a été précédemment détecté comme déchargé ou bien réaliser une opération de décharge s'il a été précédemment détecté comme chargé. Dans ce but, à chaque itération, une inversion de polarité aux bornes de l'élément de stockage est réalisée ; l'inversion de polarité cause une décharge de l'élément de stockage si l'élément de stockage est chargé et une charge de l'élément de stockage si l'élément de stockage est déchargé.

Pour chaque itération, l'inversion de polarité est réalisée avant que l'opération de charge ou bien de décharge soit lancée. Par exemple, elle peut faire suite à la détection que l'élément est chargé ou bien déchargé.

Dans des exemples il peut être réalisé une opération de la mémorisation de la nouvelle capacité $C_N$ qui vient d'être calculée. Dans un exemple, cette capacité $C_N$ peut être stockée comme une précédente valeur connue $C_{N-1}$.

Dans les exemples où une ou plusieurs itérations sont réalisées, l'opération de mémorisation est faite pour chaque itération, facilitant ainsi le calcul de la nouvelle capacité $C_N$ à chaque itération.

Dans des exemples, après l'initiation de l'opération de charge ou de décharge de l'élément électrochimique, on peut déterminer si l'élément de stockage va être chargé ou bien déchargé en fonction du sens du courant qui traverse l'élément électrochimique. Cela peut être intéressant pour la première opération de charge ou de décharge de l'élément de stockage qui fait suite à l'initiation d'une opération de charge ou de décharge de l'élément électrochimique. Dans un exemple, on peut récupérer un précédent état de charge ou de décharge connu de l'élément de stockage ; par exemple en allant le récupérer dans une mémoire. Ainsi, si on sait que l'élément de stockage est déchargé, ou encore s'il est chargé à moins de 50% de sa capacité totale, on sait que l'élément doit être chargé et on détermine à l'aide du courant traversant l'élément électrochimique si l'élément de stockage est en train d'être chargé ou déchargé. Une inversion de polarité est réalisée si besoin est. Dans un autre exemple, si après avoir récupéré le précédent état de charge ou de décharge connu de l'élément de stockage, on sait que l'élément de stockage est chargé, ou encore s'il est chargé à plus de 50% de sa capacité totale, on sait que l'élément doit être déchargé et on détermine à l'aide du courant traversant l'élément électrochimique si l'élément de stockage est en train d'être chargé ou déchargé. Une inversion de polarité est réalisée, si besoin, pour que l'élément de stockage se décharge.

Dans des exemples, l'inversion de polarité aux bornes de l'élément de stockage peut être obtenue par un envoi d'une commande de configuration d'éléments de commutation d'une structure électronique permettant de contrôler la polarité aux bornes de l'élément de stockage. Dans un exemple, la structure électronique peut être un pont en H sur lequel l'élément de stockage est connecté. Le pont en H est une structure électronique bien connue composée de quatre éléments de commutation qui sont configurés par l'envoi de la commande de configuration.

Dans des exemples, la commande de configuration peut comprendre une première commande de configuration et une deuxième commande de configuration. La première commande de configuration des éléments de commutation peut être sélectionnée après la détection que l'élément de stockage est chargé, et la deuxième commande de configuration des éléments de commutation après la détection que l'élément de stockage est déchargé. Ainsi, la première commande de configuration peut servir à commander la décharge de l'élément de stockage et la deuxième commande de configuration peut servir à commander la décharge de l'élément de stockage.

Dans des exemples, la détection que l'élément de stockage est chargé ou déchargé peut être réalisée à l'aide d'une mesure de tension $V_C$ aux bornes de l'élément de stockage. Lorsque la tension $V_C$ mesurée aux bornes de l'élément de stockage est nulle ou bien sensiblement nulle ($V_C = V_0$), l'élément de stockage est déterminé comme étant déchargé. Inversement, lorsque la tension $V_C$ mesurée aux bornes de l'élément de stockage atteint ou encore sensiblement atteint une valeur connue qui est la valeur de tension maximale ($V_{MAX} = V_C$), l'élément de stockage est déterminé comme étant chargé.

Il est maintenant discuté du calcul de l'estimation du SoC qui est exprimée en pourcentage reflétant la part d'énergie restante disponible pour l'utilisateur de l'élément électrochimique.

Dans un premier exemple, un calcul d'une première valeur de SoC de l'élément électrochimique est donné par la formule (eq. 3)

$$SoC = SoC_{initial} + 100 * (C_N / C_T) \text{ (eq. 3)}$$

où

$C_N$ est la nouvelle capacité calculée avec la formule (eq. 2) ;
$C_T$ est la capacité totale de l'élément électrochimique ;
$SoC_{initial}$ est une valeur de SoC obtenue avec la formule (eq. 4)

$$SoC_{initial} = 100 * (C_{N-1} / C_T) \text{ (eq. 4)}$$

où
la précédente valeur connue $C_{N-1}$ est la capacité de l'élément électrochimique mesurée dans la partie bijective de la courbe SoC de l'élément électrochimique lors de l'initiation de l'opération de charge ou de décharge, ou lors de l'initiation de l'opération de charge ou de décharge autre que celle actuelle.

Le terme SoC$_{initial}$ de la formule (eq. 4) correspond donc à une valeur de SOC précédemment calculée à partir d'une précédente valeur $C_{N-1}$ qui a été mesurée dans une partie de la courbe d'OCV fonction du SoC qui présente une pente suffisante pour pouvoir calibrer le SoC sur la tension aux bornes de l'élément électrochimique. Le terme SoC$_{initial}$ est donc une valeur obtenue par calibration, et toute méthode permettant une calibration du SoC sur la tension aux bornes de l'élément électrochimique peut être utilisée pour déterminer la valeur de SoC$_{initial}$.

Concernant toujours la détermination du SoC$_{initial}$, on comprend que la calibration du SoC peut être réalisée juste avant ou lors de l'initiation d'une opération de charge ou de décharge de l'élément électrochimique. Il peut s'agir de l'initiation d'une opération de charge ou de décharge actuelle, ou encore d'une précédente opération de charge ou de décharge. Dans tous les cas, la calibration ne sera réalisée que sur la partie bijective de la courbe SoC de l'élément électrochimique.

Comme déjà discuté précédemment, la capacité totale de l'élément électrochimique C$_T$ peut être sa capacité totale théorique ou bien encore sa capacité totale mesurée pour une ou des premières opérations de charge ou de décharge de l'élément électrochimique. La capacité totale peut également être obtenue à partir d'une mesure réalisée sur une charge complète de l'élément électrochimique vide ou encore sur une décharge complète de l'élément électrochimique plein.

Dans un deuxième exemple de calcul du SoC, le calcul effectué dans le premier exemple est affiné en ajoutant le terme de la formule (eq. 5) à eq. 3 :

$$\alpha * 100 * (C_{ES} / C_T) \text{ (eq. 5)}$$

où

$\alpha$ est une fraction de charge de l'élément de stockage, et C$_{ES}$ est la capacité (totale) de l'élément de stockage qui peut être la capacité totale réelle de l'élément de stockage mesurée suite à une calibration, ou encore la capacité totale théorique de l'élément de stockage. Enfin, C$_{ES}$ peut aussi être obtenue à partir d'une mesure réalisée sur une charge complète de l'élément de stockage vide ou encore sur une décharge complète de l'élément de stockage plein.

Dans ce deuxième exemple, la valeur de SoC est donc donnée par la formule (eq. 6)

$$SoC = SoC_{initial} + 100 * (C_N / C_T) + \alpha * 100 * (C_{ES} / C_T) \text{ (eq. 6)}.$$

La fraction de charge $\alpha$ est un réel compris entre 0 et 1, bornes incluses. Dans un exemple, la fraction de charge $\alpha$ est calculée à l'aide de la formule (eq. 7)

$$\alpha = V_{Bat} / V_{max} \text{ (eq. 7)}$$

où V$_{Bat}$ est la tension mesurée aux bornes de l'élément de stockage d'énergie;
V$_{Bat\_max}$ est la tension maximale connue aux bornes de l'élément de stockage d'énergie.

Par exemple, si V$_{Bat}$ = 0, alors $\alpha$=0, ou alors si V$_{Bat}$ = V$_{Bat\_Max}$ , alors $\alpha$=1, ou alors si V$_{Bat}$ = 0,5 V$_{Bat\_Max}$ , alors $\alpha$=0,5.

La fraction de charge $\alpha$ peut être déterminée quand la valeur de SoC est calculée ; alternativement, la fraction de charge $\alpha$ peut être déterminée quand la nouvelle valeur C$_N$ est obtenue.

Dans des exemples, il peut être nécessaire de capturer un nouvel état de l'élément électrochimique, et notamment les états vide (c'est-à-dire déchargé) ou plein (c'est-à-dire chargé). Un nouvel état de l'élément électrochimique peut ainsi être capturé après le calcul d'une nouvelle valeur de la capacité C$_N$. Le nouvel état de l'élément électrochimique peut être calculé en réalisant les opérations suivantes.

Dans une première étape, on mesure la tension $V_{Bat}$ de l'élément électrochimique. Cette mesure peut être réalisée à l'aide de toute méthode permettant d'obtenir cette valeur de tension $V_{Bat}$.

Dans une deuxième étape, on compare la valeur de tension $V_{Bat}$ mesurée avec deux valeurs de tension particulière ; on peut indifféremment faire la comparaison avec l'une ou l'autre de ces deux valeurs particulières. Si la tension $V_{Bat}$ mesurée est sensiblement égale à une tension minimale $V_{Bat\_Min}$ connue, on met à zéro la précédente valeur connue $C_{N-1}$. En effet, on considère dans ce cas que l'élément électrochimique est déchargé ou sensiblement déchargé, et donc que la prochaine opération ne peut être qu'une opération de charge de l'élément électrochimique avec $C_{N-1} = 0$. Inversement, si la tension $V_{Bat}$ mesurée est sensiblement égale à une tension maximale $V_{Bat\_Max}$ connue, on fixe la précédente valeur connue $C_{N-1}$ à la valeur connue de la capacité totale $C_T$ de l'élément électrochimique. En effet, on considère dans ce cas que l'élément électrochimique est chargé ou sensiblement chargé, et donc que la prochaine opération ne peut être qu'une opération de décharge de l'élément électrochimique avec $C_{N-1} = C_T$.

La méthode a été présentée dans le cadre d'une opération de charge ou de décharge de l'élément électrochimique. On comprend que la méthode peut s'appliquer à des situations où au moins une opération de charge et au moins une opération de décharge de l'élément électrochimique ont été successivement initiées, ou inversement au moins une opération de décharge et au moins une opération de charge de l'élément électrochimique ont été initiées. La méthode peut s'appliquer pour toute combinaison de succession de charge(s) et/ou décharge(s) de l'élément électrochimique.

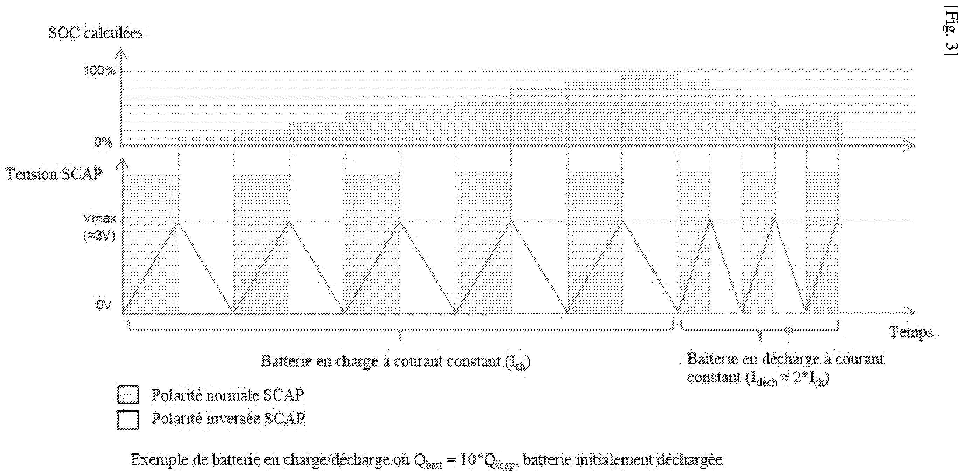

Il est maintenant discuté un exemple de la Fig. 3 qui montre, sur une première courbe, les variations en fonction du temps de valeurs du SoC calculées selon la présente invention, et, sur une deuxième courbe, les variations de la tension aux bornes de l'élément de stockage en fonction du temps. Les échelles temporelles sur les deux courbes dont identiques. Sur la partie gauche de ces deux courbes, l'élément électrochimique, une batterie, est en charge ; la batterie est en décharge sur la partie droite des deux courbes. Dans cet exemple, la batterie est totalement vide (déchargée) quand est initiée l'opération de charge à courant constant $I_{ch}$, et la batterie est totalement pleine (chargée) lorsqu'est initiée l'opération de décharge à courant constant égal à $2* I_{ch}$. Pendant les opérations de charge et de décharge, la tension aux bornes de l'élément de stockage, ici un supercondensateur (noté SCAP), varie entre 0V et $V_{MAX}$ : (i) lorsque le SCAP est en train d'être chargé, la tension passe de 0V à $V_{MAX}$, (ii) lorsque que la tension $V_{MAX}$ est atteinte, le SCAP est chargé et une inversion de polarité est déclenchée afin de décharger le SCAP, (iii) lorsque que la tension atteint à nouveau 0V, le SCAP est déchargé et une inversion de polarité est réalisée afin de charger SCAP ; (i), (ii), et (iii) sont répétées tant qu'une opération de charge ou de décharge de la batterie est en cours. A chaque changement de polarité, une nouvelle valeur de SoC est calculée. Dans cet exemple, le supercondensateur représente une fraction de la capacité totale maximale de la batterie qui est de 1/10$^{ème}$ : ainsi, à chaque charge ou décharge complète du supercondensateur, le SoC augmente de 10%.

La Fig. 3 est une combinaison particulière des exemples de procédés déjà discutés. Dans cette exemple, l'élément électrochimique est une batterie et l'élément de stockage un supercondensateur (SCAP).

A 400, une opération de charge ou de décharge est initiée.

Tant qu'il n'a pas été vérifié 410 que le SCAP est chargé ou déchargé, rien ne se produit. Lorsqu'il a été vérifié 410 que le SCAP est chargé ou déchargé, la polarité est basculée 412 aux bornes du SCAP.

La nouvelle capacité est maintenant calculée aux étapes 430, 432 ou 434 ; on comprend qu'elle aurait pu être calculée juste après 410. A 430, on vérifie quel est le sens du courant aux bornes de la batterie. Si le courant est positif, on calcule 434 la nouvelle valeur de $C_N$ selon eq. 1. SI le courant est négatif, on calcule 432 la nouvelle valeur de $C_N$ selon eq. 2.

On mémorise 440 ensuite le résultat du calcul de 432 ou 434 de telle sorte que $C_{N-1} = C_N$.

Une nouvelle valeur de SoC est calculée, par exemple avec les formules données par eq.3 ou eq.6.

On teste 460 ensuite si la tension aux bornes de la batterie est minimale, ce qui indique que la batterie est complètement déchargée. Si oui 462, la batterie est déchargée et on fixe $C_{N-1} = 0$. Si non, $C_{N-1}$ n'est pas modifiée.

On teste 470 ensuite si la tension aux bornes de la batterie est maximale, ce qui indique que la batterie est complètement chargée. Si oui 472, on fixe $C_{N-1} = C_T$ qui est la capacité totale de la batterie. Si non, $C_{N-1}$ n'est pas modifiée et le procédé peut être répété.

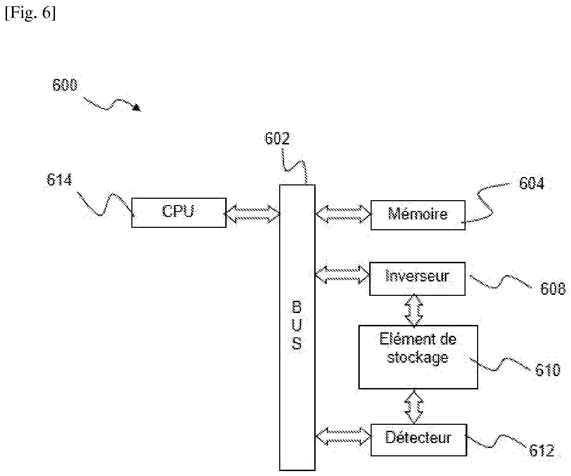

En référence à la Fig. 6, il est maintenant discuté un exemple d'un système 600 d'estimation du SoC d'un élément électrochimique.

Le système comprend un élément 610 de stockage d'énergie ayant une relation tension-niveau de charge qui est bijective pour au moins deux valeurs de la tension aux bornes de l'élément de stockage et dont la capacité $C_{ES}$ représente une partie de la capacité totale d'un élément électrochimique pour lequel on souhaiterait réaliser une estimation du SoC. Un tel élément de stockage a été précédemment discuté, et peut être par exemple un supercondensateur.

Le système comprend en outre un détecteur 612 de l'état de charge de l'élément de stockage d'énergie. Le détecteur est aussi nommé détecteur de l'état chargé ou déchargé de l'élément de stockage. Le détecteur est directement ou indirectement relié à l'élément de stockage, c'est-à-dire que le détecteur est apte à recevoir des informations concernant l'élément de stockage et lui permettant de détecter quel est l'état de charge (état chargé ou bien déchargé) de l'élément de stockage ; ces informations peuvent être directement transmises de l'élément de stockage au détecteur, ou indirectement via un autre élément du système 600. Le détecteur réalise un ou plusieurs des exemples de détection précédemment discutés.

Le système comprend également un inverseur 608 de polarité qui est connecté aux bornes de l'élément 610 de stockage d'énergie. L'inverseur de polarité permet de commander la charge ou la décharge de l'élément de stockage indépendamment du sens du courant traversant l'élément électrochimique sur lequel le système réalise la mesure du SoC. Tout comme le détecteur, l'inverseur est directement ou indirectement relié à l'élément de stockage. L'inverseur de polarité peut réaliser un ou plusieurs des exemples d'inversion de polarité précédemment discutés.

Le système comprend aussi une unité de gestion. L'unité de gestion comprend une unité de calcul (CPU) 614 qui est connectée à un bus 602 sur lequel est connectée une mémoire 604. La mémoire peut être une mémoire permettant de stocker les instructions et les données nécessaires au fonctionnement d'un programme d'ordinateur. La mémoire peut-être, mais n'est pas limitée à, une mémoire non volatile, incluant par exemple des mémoires semi-conducteurs tels que des EPROM, EEPROM, mémoire flash, des disques magnétiques, des disques magnéto-optiques, des CD-ROM, DVD-ROM, disques BlueRay©. Tous ces éléments peuvent être suppléés par ou incorporés dans, des ASICs (acronyme anglais de « application-specific integrated circuits »). L'unité de gestion peut commander l'inverseur de polarité 608 ; pour cela, l'inverseur de polarité peut communiquer avec l'unité de gestion via le BUS 602. L'unité de gestion peut également recevoir des informations provenant du détecteur 612, telle que les résultats de la détection ; pour cela, le détecteur peut communiquer avec l'unité de gestion via le BUS 602.

Le programme d'ordinateur peut comprendre des instructions exécutables par l'unité de gestion. Les instructions comprennent des moyens pour amener le système à exécuter le procédé selon l'invention. Le programme peut être enregistrable sur n'importe quel support de stockage de données, y compris la mémoire de l'unité de gestion. Le programme peut, par exemple, être mis en oeuvre dans des circuits électroniques numériques, ou dans du matériel informatique, des micrologiciels, des logiciels ou des combinaisons de ceux-ci. Le programme peut être mis en oeuvre sous la forme d'un appareil, par exemple un produit incorporé de manière tangible dans un dispositif de stockage lisible par machine pour une exécution par un processeur programmable. Les étapes du procédé peuvent être exécutées par un processeur programmable exécutant un programme d'instructions pour exécuter des fonctions du procédé en opérant sur des données d'entrée et en générant une sortie. Le processeur peut ainsi être programmé et couplé pour recevoir des données et des instructions, pour transmettre des données et des instructions à un système de stockage de données, à au moins un dispositif d'entrée et à au moins un dispositif de sortie. Le programme d'ordinateur peut être implémenté dans un langage de programmation procédural ou orienté objet de haut niveau, ou en langage assembleur ou machine si nécessaire. Dans tous les cas, le langage peut être un langage compilé ou interprété. Le programme peut être un programme d'installation complet ou un programme de mise à jour. L'application du programme sur le système entraîne dans tous les cas des instructions pour l'exécution de la méthode.

La mémoire du système de la Fig. 6 stocke le programme d'ordinateur qui comprend les instructions de code de programme pour l'exécution du procédé d'estimation du SoC selon l'invention.

La mémoire est de plus apte à mémoriser au moins une précédente valeur connue de la capacité $C_{N-1}$ de l'élément électrochimique, ainsi qu'une valeur connue de la capacité totale $C_T$ de l'élément électrochimique.

Dans des exemples, l'inverseur de polarité est une structure électronique de pont en H qui comprenant des éléments de commutation. La Fig. 2 montre une telle structure de pont en H sur laquelle l'élément de stockage d'énergie est électriquement relié. Le pont en H comprend dans cet exemple quatre éléments de commutation notés A, B, C et D.

Lorsque le système d'estimation du SoC est couplé à un élément électrochimique dont on souhaite estimer le SoC, l'élément de stockage d'énergie est connecté à l'élément électrochimique de sorte que le courant qui traverse l'élément électrochimique traverse également l'élément de stockage. Dans la Fig. 2, la structure de pont en H est disposée par rapport à l'élément électrochimique de telle sorte que le courant qui traverse l'élément électrochimique traverse également l'élément de stockage.

Dans des exemples, le système d'estimation du SoC peut également comprendre une unité de commande des commutateurs de la structure de pont en H. L'unité de commande peut être couplée au détecteur de l'état de charge de l'élément de stockage d'énergie de façon à ce que lorsque détecteur détecte que l'élément de stockage est chargé ou déchargé, l'unité de commande en soit informée et qu'elle puisse reconfigurer les commutateurs du pont en H pour qu'ils inversent la polarité aux bornes de l'élément de stockage.

Dans des exemples, le détecteur de l'état de charge de l'élément de stockage d'énergie est apte à détecter l'état de charge en fonction d'une tension $V_c$ aux bornes de l'élément de stockage. Le détecteur peut être un comparateur de tension qui est apte à recevoir une valeur de la tension $V_C$ aux bornes de l'élément de stockage. Le détecteur peut comprendre un premier comparateur de tension apte à déterminer que la tension $V_C$ est sensiblement nulle. Le détecteur peut également comprendre un deuxième comparateur de tension apte à déterminer que la tension $V_C$ est sensiblement égale à une valeur de tension maximale $V_{C\_Max}$. Cette valeur de $V_{C\_Max}$ peut être stockée dans la mémoire 604, ou encore tout autre mémoire pouvant être accédée par le détecteur. Sur la Fig. 2, le détecteur produit en sortie un premier signal LL (Low Level) indiquant que l'élément de stockage est déchargé, et un deuxième signal UL (Upper Level) indiquant que l'élément de stockage est chargé.

Dans des exemples, l'unité de commande des commutateurs comprend une bascule couplée au détecteur de l'état de charge de l'élément le de stockage d'énergie. Dans l'exemple de la Fig. 2, la bascule est une bascule Flip-Flop. La bascule est apte à recevoir au moins un premier signal et un deuxième signal provenant du détecteur de l'état de charge de l'élément de stockage d'énergie, le premier représentant une détection que l'élément de stockage est chargé et un deuxième signal du détecteur représentant une détection que l'élément de stockage est déchargé. La bascule est de plus apte à maintenir un premier état de sortie suite à la réception du premier signal et un deuxième état de sortie suite à la réception du deuxième signal. En d'autres termes, la bascule produit au moins deux signaux en sortie qui dépendent du résultat de la détection. Chacun de ces au moins deux signaux permettent de maintenir une certaine polarité aux bornes de l'élément de stockage. Sur la Fig. 2, le signal UL fait produire à la bascule Flip-Flop un premier signal qui permet de maintenir une polarisation de l'élément de stockage qui le charge. Le signal LL fait produire à la bascule Flip-Flop un deuxième signal qui permet de maintenir une polarisation sur l'élément de stockage qui le décharge.

Dans des exemples, l'unité de commande de commutateurs peut comprendre en outre des pilotes des éléments de commutation qui sont couplés à la bascule. Les pilotes sont des éléments permettant de commander les commutateurs de l'inverseur de polarité. Dans un exemple, les pilotes peuvent être aptes à recevoir le premier état de sortie et le deuxième état de sortie qui lui sont envoyés par la bascule. Les pilotes sont aptes à configurer les éléments de commutation selon une première configuration sur réception du premier état de sortie et selon une deuxième configuration sur réception du deuxième état de sortie. Sur la Fig. 2, lorsque les pilotes reçoivent le premier signal émis par la bascule, ils configurent les commutateurs pour que la structure de pont en H puisse charger l'élément de stockage, par exemple les commutateurs A et D sont fermés et les commutateurs B et C sont ouverts. Inversement, les pilotes vont configurés A et D ouverts et B et C fermés lorsque la bascule leur transmet le deuxième signal.

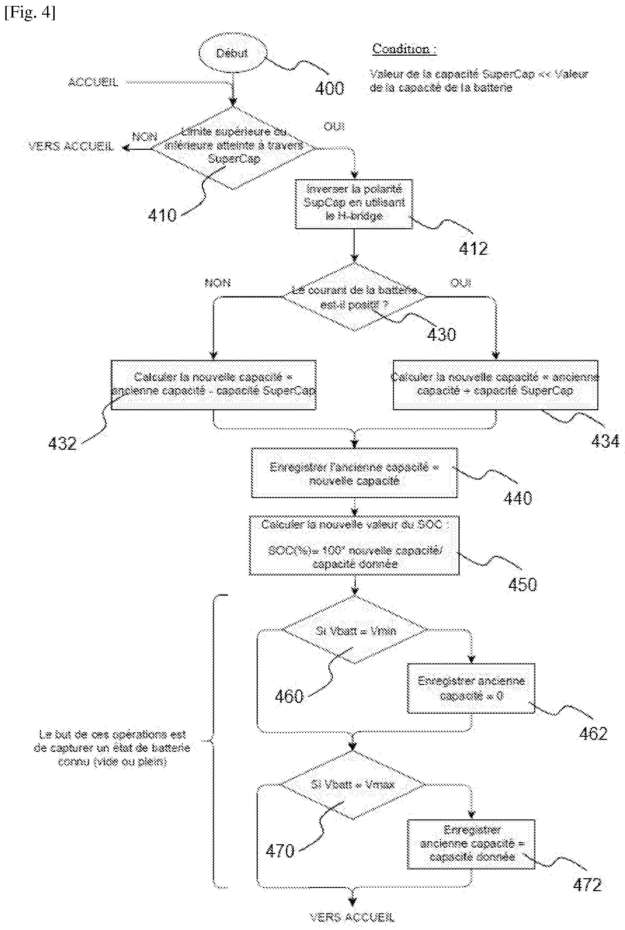

L'unité de gestion de l'exemple de la Fig. 2 peut recevoir des valeurs de tension aux bornes de la batterie, par exemple pour réaliser les étapes 460/462 et 470/472 de la Fig. 4. Elle peut également recevoir le sens du courant dans la batterie, par exemple pour réaliser les étapes 430/432/434 de la Fig. 4. Ainsi, dans des exemples, Dans des exemples, le système peut comprendre un détecteur du sens du courant de l'élément électrochimique. L'unité de gestion peut également réaliser les étapes 440 et 450 de la Fig. 4. Dans l'exemple de la FIG.2, les étapes 410/412 et 430 sont réalisées par des éléments distincts de l'unité de gestion. On comprend que l'unité de gestion peut être aptes à réaliser ces fonctions de détecter que l'élément de stockage est chargé ou déchargé et de gestion de la polarité aux bornes de l'élément de stockage.

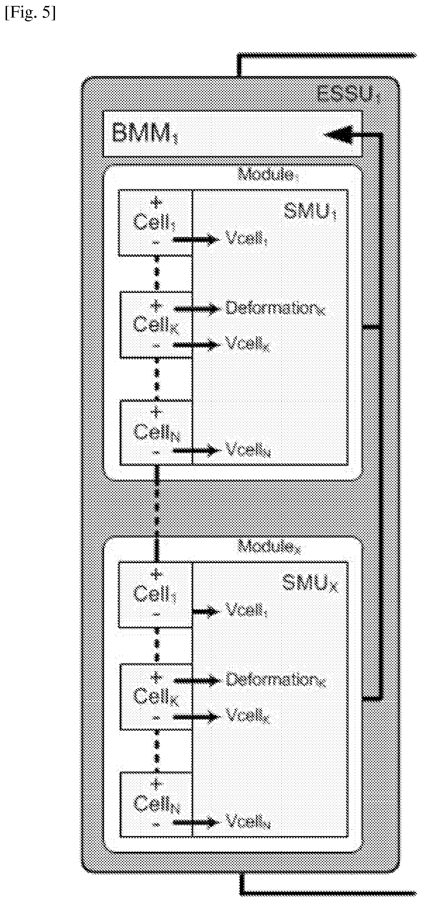

La Fig. 5 est un exemple de configuration d'une batterie dans laquelle N éléments électrochimiques (Cell1, Cell2,..., CellN) sont connectés en série et disposés ensemble dans une même enceinte pour former un premier module (Module 1). De manière similaire, N éléments électrochimiques sont connectés en série et disposés dans une xième enceinte pour former un xième module (Modulex). Les X modules sont connectés en série pour former une batterie (Bat). Les X modules constituent une branche du circuit. Les éléments ne sont pas non plus nécessairement connectés en série mais peuvent aussi être connectés en parallèle. Il est également envisageable de connecter certains éléments entre eux en parallèle pour obtenir plusieurs associations d'éléments en parallèle puis de connecter ces associations d'éléments en série. De même, la batterie peut comprendre un nombre quelconque de modules, dans une configuration non nécessairement limitée à une connexion en série. Par exemple, la batterie peut comprendre p branches parallèles, chaque branche parallèle comprenant au moins un élément ou au moins un module.

Chaque élément peut être muni d'un moyen de mesure de la tension à ses bornes. De préférence, un élément est aussi muni d'un moyen permettant de mesurer sa température de fonctionnement. Ce moyen de mesure est placé sur un point judicieusement choisi de l'élément afin d'avoir une représentation de sa température moyenne et/ou maximale et/ou minimale. Si la batterie comprend une pluralité d'éléments, chaque élément peut être muni d'un capteur de température mais cela rend plus complexe les circuits électroniques.

Le procédé d'évaluation du SoC selon l'invention s'applique à tout type d'élément électrochimique. Le procédé est notamment adapté aux éléments électrochimiques du type ayant une courbe de tension à vide (OCV) en fonction de l'état de charge (SoC) comprenant une zone plate, la relation entre l'état de charge et la tension en circuit ouvert (OCV) pouvant être non-bijective. Il est par exemple connu de tels éléments des documents EP-A-2 144 075, EP-A-2 239 826 et EP-A-2 309 615 dans lesquels on utilise comme matériau d'électrode positive d'un élément des phosphates lithiés d'au moins un métal de transition, notamment les composés de type $LiMPO_4$ où M est choisi dans le groupe comprenant Fe, Co, Ni, Mn et un mélange de ceux-ci.

De plus, le procédé selon l'invention peut s'appliquer à tout type d'élément électrochimique, indépendamment de son format. Dans des exemples non-limitatifs, l'élément électrochimique peut se présenter sous une forme cylindrique, prismatique, de bouton, de poche (aussi connu sous le nom anglais de « pouch »). Dans un exemple, un élément électrochimique de type « pouch » comprend au moins une cellule pouvant comprendre une plaque métallique intégrant une électrode positive, une électrode négative et un séparateur. Une telle cellule résulte de l'assemblage par juxtaposition d'un ensemble de composants se présentant sous la forme de feuilles souples réunies dans une enveloppe, et formant ainsi un élément de type « pouch ».

De plus, le procédé selon l'invention peut également s'appliquer à différents types d'assemblages de batteries. Par exemple, la batterie peut comprendre un élément électrochimique, ou encore deux ou plus éléments électrochimiques, et/ou un ou plusieurs modules. Les éléments électrochimiques et/ou les modules de la batterie peuvent être montés en série et/ou en parallèle. Par exemple, une configuration de batterie peut comprendre p branches montées en parallèle, chaque branche comprenant un ou plusieurs éléments électrochimiques et/ou modules. Chaque branche peut comprendre un système d'estimation du SoC, et le SoC global du système de batteries peut être par exemple calculé à partir du calcul de SoC effectué pour chaque branche. Par exemple, le SoC global est une valeur moyenne de toutes les valeurs de SoC. Alternativement, un système d'estimation du SoC peut estimer le SoC pour plusieurs branches ; le système d'estimation du SoC peut alors comprendre et gérer autant d'éléments de stockage d'énergie, de détecteur de l'état de charge de l'élément de stockage d'énergie et d'inverseur de polarité connecté aux bornes de l'élément de stockage d'énergie qu'il y a de branches. Une seule unité de calcul peut être nécessaire. Un seul détecteur peut être nécessaire pour l'ensemble des éléments de stockage d'énergie.

**Revendications**

1. Procédé d'estimation de l'état de charge (SoC) d'un élément électrochimique, comprenant :

   - une initiation (400) d'une opération de charge ou de décharge de l'élément électrochimique qui est traversé par un courant ;
   - pendant l'opération de charge ou de décharge de l'élément électrochimique :

     -- une opération de charge ou une décharge d'un élément de stockage d'énergie qui est traversé par le même courant que l'élément électrochimique, l'élément de stockage d'énergie ayant une relation tension-niveau de charge qui est bijective pour au moins deux valeurs de la tension aux bornes de l'élément de stockage, la capacité CES de l'élément de stockage représentant une partie de la capacité totale de l'élément électrochimique;
     --une détection (410) que l'élément de stockage est chargé ou déchargé ;
     -- un calcul (430) d'une nouvelle valeur de la capacité CN de l'élément électrochimique par la formule :

       --- pour une opération de charge (434) :

$$C_N = C_{N-1} + C_{ES} \ ;$$

       --- pour une opération de décharge (432) : :

$$C_N = C_{N-1} - C_{ES} \, ;$$

       où $C_{N-1}$ est une précédente valeur connue de la capacité de l'élément électrochimique,

   **caractérisé en ce que** le procédé comprend en outre :

   - suite à la détection que l'élément de stockage est chargé ou déchargé, une inversion (412) de polarité aux bornes de l'élément de stockage causant une décharge de l'élément de stockage si l'élément de stockage est chargé et une charge de l'élément de stockage si l'élément de stockage est déchargé ;
   - une itération de la charge ou décharge de l'élément de stockage, de la détection, et du calcul.

2. Procédé selon la revendication 1, dans lequel l'inversion de polarité comprend :

   - un envoi d'une commande de configuration d'éléments de commutation d'une structure électronique de pont en H sur laquelle structure électronique l'élément de stockage est connecté, et

   dans lequel la commande de configuration comprend :

   - la sélection d'une première commande de configuration des éléments de commutation après la détection que l'élément de stockage est chargé ;
   - la sélection d'une deuxième commande de configuration des éléments de commutation après la détection que l'élément de stockage est déchargé.

3. Procédé selon l'une quelconque des revendications précédentes, comprenant en outre un calcul (450) d'une première valeur de SoC de l'élément électrochimique par une première formule :

$$SoC = SoC_{initial} + 100 * (C_N / C_T)$$

Où

$C_T$ est la capacité maximale de l'élément électrochimique ;
$SoC_{initial}$ est une valeur de SoC obtenue avec la formule

$$SoC_{initial} = 100 * (C_{N-1} / C_T)$$

où la précédente valeur connue $C_{N-1}$ est la capacité de l'élément électrochimique mesurée dans la partie bijective de la courbe SoC de l'élément électrochimique lors d'une initiation d'une opération de charge ou de décharge, et dans lequel le calcul de la valeur de SoC de l'élément électrochimique comprend le calcul d'une deuxième formule

$$SoC = SoC_{initial} + 100 * (C_N / C_T) + \alpha * 100 * (C_{ES} / C_T)$$

où

$\alpha$ est une fraction de charge de l'élément de stockage à l'instant où la valeur de SoC est calculée.

4. Procédé selon l'une quelconque des revendications précédentes, comprenant en outre successivement l'initiation d'au moins une opération de charge et d'au moins une opération de décharge de l'élément électrochimique, ou inversement l'initiation d'au moins une opération de décharge et d'au moins une opération de charge de l'élément électrochimique.

5. Procédé selon l'une quelconque des revendications précédentes, comprenant en outre, après le calcul de la nouvelle valeur de la capacité $C_N$ :

    - la mémorisation de la capacité $C_N$ comme étant une précédente valeur connue $C_{N-1}$.

6. Procédé selon l'une quelconque des revendications précédentes, comprenant en outre, pendant la réalisation de l'opération de charge ou de décharge :

    - une détection du sens du courant aux bornes de l'élément électrochimique ; et
    - la détermination qu'une opération de charge ou de décharge de l'élément électrochimique est réalisée selon le sens du courant détecté.

7. Procédé selon l'une quelconque des revendications précédentes, dans lequel la détection que l'élément de stockage est chargé ou déchargé comprend :

    - une mesure d'une tension $V_C$ aux bornes de l'élément de stockage ;
    - une détermination que l'élément de stockage est déchargé si la tension mesurée est sensiblement nulle ;
    - une détermination que l'élément de stockage est chargé si la tension mesurée est sensiblement égale à une valeur de tension maximale connue.

8. Procédé selon l'une quelconque des revendications précédentes, comprenant en outre, après le calcul de la nouvelle valeur de la capacité $C_N$ :

    une mesure de tension $V_{Bat}$ de l'élément électrochimique ;
    si la tension $V_{Bat}$ mesurée est sensiblement égale à une tension minimale $V_{Bat\_Min}$ connue (460), la mise à zéro (462) de la valeur de la précédente valeur connue $C_{N-1}$ ;
    si la tension $V_{Bat}$ mesurée est sensiblement égale à une tension maximale $V_{Bat\_Max}$ connue (470), la fixation (472) de la précédente valeur connue $C_{N-1}$ à la valeur connue de la capacité total $C_T$ de l'élément électrochimique.

9. Programme d'ordinateur comprenant des instructions de code de programme pour l'exécution du procédé selon l'une des revendications 1 à 8.

**10.** Système de mesure de l'état de charge (SoC) d'un élément électrochimique, comprenant :

- un élément de stockage d'énergie ayant une relation tension-niveau de charge qui est bijective pour au moins deux valeurs de la tension aux bornes de l'élément de stockage et dont la capacité $C_{ES}$ représente une partie de la capacité totale de l'élément ;
- un détecteur de l'état de charge de l'élément de stockage d'énergie ;
- un inverseur de polarité connecté aux bornes de l'élément de stockage d'énergie ;
- une unité de calcul en communication avec le détecteur et l'inverseur, et couplée à une mémoire, la mémoire stockant un programme d'ordinateur comprenant des instructions de code de programme pour l'exécution du procédé selon l'une des revendications 1 à 5 et étant apte à mémoriser au moins une précédente valeur connue de la capacité $C_{N-1}$ de l'élément électrochimique, une valeur connue de la capacité totale $C_T$ de l'élément électrochimique.

**11.** Système selon la revendication 10, dans lequel :

- l'inverseur de polarité est une structure électronique de pont en H comprenant des éléments de commutation ;

et comprenant en outre :

- une unité de commande des éléments de commutation, l'unité de commande étant couplée au détecteur de l'état de charge de l'élément de stockage d'énergie et comprenant :
- une bascule couplée au détecteur de l'état de charge de l'élément de stockage d'énergie, la bascule étant apte à :

    -- recevoir au moins un premier signal et un deuxième signal provenant du détecteur de l'état de charge de l'élément de stockage d'énergie, le premier représentant une détection que l'élément de stockage est chargé et un deuxième signal du détecteur représentant une détection que l'élément de stockage est déchargé ;
    -- maintenir un premier état de sortie suite à la réception du premier signal et un deuxième état de sortie suite à la réception du deuxième signal ;

- des pilotes des éléments de commutation, les pilotes étant couplés à la bascule et aptes à :

    -- recevoir le premier état de sortie et le deuxième état de sortie ;
    -- configurer les éléments de commutation selon une première configuration sur réception du premier état de sortie et selon une deuxième configuration sur réception du deuxième état de sortie.

**12.** Système selon l'une quelconque des revendications 10 à 11, dans lequel le détecteur de l'état de charge de l'élément de stockage d'énergie est en outre apte à recevoir une valeur d'une tension $Vc$ aux bornes de l'élément de stockage, le détecteur comprenant :

- un premier comparateur de tension apte à déterminer que la tension $Vc$ est sensiblement nulle ;
- un deuxième comparateur de tension apte à déterminer que la tension $V_C$ est sensiblement égale à une valeur de tension maximale $V_{C\_Max}$ stockée dans la mémoire.

**13.** Système selon l'une des revendications 10 à 12, dans lequel l'élément de stockage d'énergie est un supercondensateur.

**14.** Ensemble comprenant :

- le système de mesure du SoC selon l'une des revendications 10 à 13 ;
- un élément électrochimique couplé avec le système de mesure du SoC.

**15.** Ensemble selon la revendication 14, dans lequel l'élément électrochimique est celui d'une batterie comprenant un ou plus éléments électrochimiques.

**16.** Ensemble selon la revendication 15, dans lequel la batterie comprend deux ou plus branches, chaque branche comprenant un ou plusieurs éléments électrochimiques et étant couplée avec un système de mesure du SoC.

**Patentansprüche**

1. Verfahren zum Schätzen des Ladezustands (SoC) eines elektrochemischen Elements, umfassend:

   - eine Einleitung (400) eines Lade- oder Entladevorgangs des elektrochemischen Elements, das von einem Strom durchflossen wird;
   - während des Lade- oder Entladevorgangs des elektrochemischen Elements:

     -- einen Ladevorgang oder eine Entladung eines Energiespeicherelements, das von demselben Strom wie das elektrochemische Element durchflossen wird, wobei das Energiespeicherelement ein Verhältnis Spannung-Ladungspegel aufweist, das für mindestens zwei Werte der Spannung an den Klemmen des Speicherelements bijektiv ist, wobei die CES-Kapazität des Speicherelements einen Teil der Gesamtkapazität des elektrochemischen Elements darstellt;
     -- ein Erkennen (410), dass das Speicherelement geladen oder entladen wird;
     -- ein Berechnen (430) eines neuen Werts der CN-Kapazität des elektrochemischen Elements durch die Formel:

        --- für einen Ladevorgang (434):

$$C_N = C_{N-1} + C_{ES}$$

        --- für einen Entladevorgang (432):

$$C_N = C_{N-1} - C_{ES};$$

   wobei $C_{N-1}$ ein früherer bekannter Wert der Kapazität des elektrochemischen Elements ist, **dadurch gekennzeichnet, dass** das Verfahren ferner Folgendes umfasst:

   - nach dem Erkennen, dass das Speicherelement geladen oder entladen ist, Umkehren (412) der Polarität an den Klemmen des Speicherelements, was eine Entladung des Speicherelements, wenn das Speicherelement geladen ist, und ein Laden des Speicherelements, wenn das Speicherelement entladen ist, verursacht;
   - ein Wiederholen des Ladens oder Entladens des Speicherelements, des Erkennens und des Berechnens.

2. Verfahren nach Anspruch 1, wobei das Umkehren der Polarität Folgendes umfasst:

   - ein Senden eines Konfigurationsbefehls von Schaltelementen einer elektronischen Struktur einer H-Brücke, wobei das Speicherelement mit der elektronischen Struktur verbunden ist, und

   wobei der Konfigurationsbefehl Folgendes umfasst:

   - Auswählen eines ersten Konfigurationsbefehls der Schaltelemente, nachdem erkannt wurde, dass das Speicherelement geladen ist;
   - Auswählen eines zweiten Konfigurationsbefehls der Schaltelemente, nachdem erkannt wurde, dass das Speicherelement entladen ist.

3. Verfahren nach einem der vorherigen Ansprüche, ferner umfassend ein Berechnen (450) eines ersten SoC-Werts des elektrochemischen Elements durch eine erste Formel:

$$SoC = SoC_{initial} + 100 * (C_N / C_T)$$

   wobei

   $C_T$ die maximale Kapazität des elektrochemischen Elements ist; $SoC_{initial}$ ein Wert für SoC ist, der mit der Formel

$$SoC_{initial} = 100 * (C_{N-1} / C_T) \text{ erlangt wird,}$$

wobei
der vorherige bekannte Wert $C_{N-1}$ die Kapazität des elektrochemischen Elements ist, die in dem bijektiven Abschnitt der SoC-Kurve des elektrochemischen Elements beim Einleiten eines Lade- oder Entladevorgangs gemessen wird, und
wobei das Berechnen des SoC-Werts des elektrochemischen Elements das Berechnen einer zweiten Formel umfasst

$$SoC = SoC_{initial} + 100 * (C_N / C_T) + \alpha * 100 * (C_{ES} / C_T)$$

wobei
$\alpha$ ein Bruchteil der Ladung des Speicherelements zu dem Zeitpunkt ist, an dem der SoC-Wert berechnet wird.

4. Verfahren nach einem der vorherigen Ansprüche, ferner umfassend nacheinander das Einleiten von mindestens einem Ladevorgang und mindestens einem Entladevorgang des elektrochemischen Elements oder umgekehrt das Einleiten von mindestens einem Entladevorgang und mindestens einem Ladevorgang des elektrochemischen Elements.

5. Verfahren nach einem der vorherigen Ansprüche, ferner umfassend, nach dem Berechnen des neuen Werts der Kapazität $C_N$:

   - das Speichern der Kapazität $C_N$ als einen vorherigen bekannten Wert $C_{N-1}$.

6. Verfahren nach einem der vorherigen Ansprüche, ferner umfassend während der Durchführung des Lade- oder Entladevorgangs:

   - ein Erkennen der Richtung des Stroms an den Klemmen des elektrochemische Elements; und
   - das Bestimmen, dass ein Lade- oder Entladevorgang des elektrochemischen Elements durchgeführt wird, gemäß der Richtung des erkannten Stroms.

7. Verfahren nach einem der vorherigen Ansprüche, wobei das Erkennen, dass das Speicherelement geladen oder entladen ist, Folgendes umfasst:

   - ein Messen einer Spannung Vc an den Klemmen des Speicherelements;
   - ein Bestimmen, dass das Speicherelement entladen ist, wenn die gemessene Spannung im Wesentlichen null ist;
   - ein Bestimmen, dass das Speicherelement geladen ist, wenn die gemessene Spannung im Wesentlichen gleich wie ein bekannter maximaler Spannungswert ist.

8. Verfahren nach einem der vorherigen Ansprüche, ferner umfassend, nach dem Berechnen des neuen Werts der Kapazität $C_N$:

   ein Messen der Spannung $V_{Bat}$ des elektrochemischen Elements;
   wenn die gemessene Spannung $V_{Bat}$ im Wesentlichen gleich wie eine bekannte minimale Spannung $V_{Bat\_Min}$ (460) ist, Setzen (462) des Werts auf den vorherigen bekannten Wert $C_{N-1}$;
   wenn die gemessene Spannung $V_{Bat}$ im Wesentlichen gleich wie eine bekannte maximale Spannung $V_{Bat\_Max}$ (470) ist, Setzen (472) des vorherigen bekannten Werts $C_{N-1}$ auf den bekannten Wert der Gesamtkapazität $C_T$ des elektrochemischen Elements.

9. Computerprogramm, umfassend Programmcodeanweisungen zum Ausführen des Verfahrens nach einem der Ansprüche 1 bis 8.

10. System zum Messen des Ladezustands (SoC) eines elektrochemischen Elements, umfassend:

   - ein Energiespeicherelement, das ein Verhältnis Spannung-Ladungspegel aufweist, das für mindestens zwei Werte der Spannung an den Klemmen des Speicherelements bijektiv ist, und dessen Kapazität $C_{ES}$ einen Teil der Gesamtkapazität des Elements darstellt;
- einen Detektor des Ladezustand des Energiespeicherelements;
- einen Polaritätsinverter, der mit den Klemmen des Energiespeicherelements verbunden ist;
- eine Recheneinheit, die mit dem Detektor und dem Inverter in Verbindung ist und mit einem Speicher gekoppelt ist, wobei der Speicher ein Computerprogramm speichert, umfassend Programmcodeanweisungen zum Ausführen des Verfahrens nach einem der Ansprüche 1 bis 5 und das geeignet ist, um mindestens einen vorherigen bekannten Wert der Kapazität $C_{N-1}$ des elektrochemischen Elements, einen bekannten Wert der Gesamtkapazität $C_T$ des elektrochemischen Elements zu speichern.

**11.** System nach Anspruch 10, wobei:

- der Polaritätsinverter eine elektronische H-Brückenstruktur, umfassend Schaltelemente;

und ferner umfassend:

- eine Steuereinheit für die Schaltelemente, wobei die Steuereinheit mit dem Detektor des Ladezustands des Energiespeicherelements gekoppelt ist und Folgendes umfasst:
- eine Wippe, die mit dem des Ladezustands des Energiespeicherelements gekoppelt ist, wobei die Wippe zu Folgendem geeignet ist:

-- Empfangen mindestens eines ersten Signals und eines zweiten Signals von dem Detektor des Ladezustands des Energiespeicherelements, wobei das erste Signal ein Erkennen darstellt, dass das Speicherelement geladen ist, und ein zweites Signal von dem Detektor ein Erkennen darstellt, dass das Speicherelement entladen ist;
-- Aufrechterhalten eines ersten Ausgangszustands nach Empfangen des ersten Signals und eines zweiten Ausgangszustands nach Empfangen des zweiten Signals;

- Treiber der Schaltelemente, wobei die Treiber mit der Wippe gekoppelt und zu Folgendem geeignet sind,:

-- Empfangen des ersten Ausgabestatus und des zweiten Ausgabestatus;
-- Konfigurieren der Schaltelemente gemäß einer ersten Konfiguration bei Empfangen des ersten Ausgangszustands und gemäß einer zweiten Konfiguration bei Empfangen des zweiten Ausgangszustands.

**12.** System nach einem der Ansprüche 10 bis 11, wobei der Detektor des Ladezustands des Energiespeicherelements zusätzlich geeignet ist, um einen Wert einer Spannung Vc an den Klemmen des Speicherelements zu empfangen, der Detektor umfassend:

- einen ersten Spannungskomparator, der geeignet ist, um zu bestimmen, ob die Spannung Vc im Wesentlichen Null ist;
- einen zweiten Spannungskomparator, der geeignet ist, um zu bestimmen, ob die Spannung Vc im Wesentlichen gleich wie ein maximaler Spannungswert $V_{C\_Max}$ ist, der in dem Speicher gespeichert ist.

**13.** System nach einem der Ansprüche 10 bis 12, wobei das Energiespeicherelement ein Superkondensator ist.

**14.** Anordnung, umfassend:

- das SoC-Messsystem nach einem der Ansprüche 10 bis 13;
- ein elektrochemisches Element, das mit dem SoC-Messsystem gekoppelt ist.

**15.** Anordnung nach Anspruch 14, wobei das elektrochemische Element jenes einer Batterie ist, umfassend ein oder mehrere elektrochemische Elemente.

**16.** Anordnung nach Anspruch 15, wobei die Batterie zwei oder mehrere Zweige umfasst, jeder Zweig umfassend ein oder mehrere elektrochemische Elemente und mit einem Messsystem des SoC gekoppelt ist.

# EP 3 999 863 B1

**Claims**

1. A method for estimating the state of charge (SoC) of an electrochemical element, comprising:

   - initiating (400) an operation of charging or discharging the electrochemical element that is traversed by a current;
   - during the operation of charging or discharging the electrochemical element:

     -- an operation of charging or discharging a power storage element that is traversed by the same current as the electrochemical element, the power storage element having a voltage/charge level relationship that is bijective for at least two values of the voltage at the terminals of the storage element, the capacity CES of the storage element representing a portion of the total capacity of the electrochemical element;
     -- detecting (410) that the storage element is charged or discharged;
     -- computing (430) a new value of the capacity CN of the electrochemical element by means of the formula:

       --- for a charging operation (434):

$$C_N = C_{N-1} + C_{ES};$$

       --- for a discharging operation (432):

$$C_N = C_{N-1} - C_{ES};$$

   where $C_{N-1}$ is a previous known value of the capacity of the electrochemical element, **characterized in that** the method further comprises:

   - following the detection that the storage element is charged or discharged, a polarity inversion (412) at the terminals of the storage element causing discharging of the storage element if the storage element is charged and charging of the storage element if the storage element is discharged;
   - an iteration of the charging or discharging of the storage element, the detection and the computing.

2. The method according to claim 1, wherein the polarity inversion comprises:

   - sending a configuration command for switching elements of an electronic H-bridge structure, on which electronic structure the storage element is connected, and

   wherein the configuration command comprises:

   - selecting a first configuration command of the switching elements after detecting that the storage element is charged;
   - selecting a second configuration command of the switching elements after detecting that the storage element is discharged.

3. The method according to any one of the preceding claims, further comprising computing (450) a first SoC value of the electrochemical element by a first formula:

$$SoC = SoC_{initial} + 100 * (C_N / C_T)$$

   wherein

   $C_T$ is the maximum capacity of the electrochemical element; $SoC_{initial}$ is an SoC value obtained with the formula

$$SoC_{initial} = 100 * (C_{N-1} / C_T)$$

   wherein

the previous known value $C_{N-1}$ is the capacity of the electrochemical element measured in the bijective portion of the SoC curve of the electrochemical element during an initiation of a charging or discharging operation, and wherein the computing of the SoC value of the electrochemical element comprises computing a second formula

$$SoC = SoC_{initial} + 100 * (C_N / C_T) + \alpha * 100 * (C_{ES} / C_T)$$

wherein
$\alpha$ is a charging fraction of the storage element at the instant where the SoC value is computed.

4. The method according to any one of the preceding claims, further comprising successively initiating at least one charging operation and at least one discharging operation of the electrochemical element, or conversely initiating at least one discharging operation and at least one charging operation of the electrochemical element.

5. The method according to any one of the preceding claims, further comprising, after computing the new value of the capacity $C_N$:

   - storing the capacity $C_N$ as a previous known value $C_{N-1}$.

6. The method according to any one of the preceding claims, further comprising, during the performance of the charging or discharging operation:

   - detecting the direction of the current at the terminals of the electrochemical element; and
   - determining that a charging or discharging operation of the electrochemical element is done in the detected current direction.

7. The method according to any one of the preceding claims, wherein the detection that the storage element is charged or discharged comprises:

   - measuring a voltage $V_C$ at the terminals of the storage element;
   - determining that the storage element is discharged if the measured voltage is substantially zero;
   - determining that the storage element is charged if the measured voltage is substantially equal to a known maximum voltage value.

8. The method according to any one of the preceding claims, further comprising, after computing the new value of the capacity $C_N$:

   a voltage measurement $V_{Bat}$ of the electrochemical element;
   if the measured voltage $V_{Bat}$ is substantially equal to a known minimum voltage $V_{Bat\_Min}$ (460), resetting (462) the value of the previous known value $C_{N-1}$;
   if the measured voltage $V_{Bat}$ is substantially equal to a known maximum voltage $V_{Bat\_Max}$ (470), setting (472) the previous known value $C_{N-1}$ to the known value of the total capacity $C_T$ of the electrochemical element.

9. A computer program comprising program code instructions for executing the method according to one of claims 1 to 8.

10. A system for measuring the state of charge (SoC) of an electrochemical element, comprising:

    - a power storage element having a voltage/charge level relationship that is bijective for at least two values of the voltage at the terminals of the storage element and the capacity $C_{ES}$ of which represents a portion of the total capacity of the electrochemical element;
    - a detector of the state of charge of the power storage element;
    - a polarity inverter connected to the terminals of the power storage element;
    - a computing unit in communication with the detector and the inverter, and coupled to a memory, the memory storing a computer program comprising program code instructions for executing the method according to one of claims 1 to 5 and able to store at least one previous known value of the capacity $C_{N-1}$ of the electrochemical element, a known value of the total capacity $C_T$ of the electrochemical element.

11. The system according to claim 10, wherein:

- the polarity inverter is an electronic H-bridge structure comprising switching elements; and further comprising:

- a control unit of the switching elements, the control unit being coupled to the state of charge detector of the power storage element and comprising:
- a latch coupled to the detector of the state of charge of the power storage element, the latch being able to:

-- receive at least a first signal and a second signal coming from the state of charge detector of the power storage element, the first representing a detection that the storage element is charged and a second signal from the detector representing a detection that the storage element is discharged;
-- maintain a first output state after receiving the first signal and a second output state after receiving the second signal;

- drivers of switching elements, the drivers being coupled to the latch and being able to:

-- receive the first output state and the second output state;
-- configure the switching elements according to a first configuration on receiving the first output state and according to a second configuration on receiving the second output state.

12. The system according to any one of claims 10 to 11, wherein the state of charge detector of the power storage element is further able to receive a value of a voltage $V_C$ at the terminals of the storage element, the detector comprising:

- a first voltage comparator able to determine that the voltage $V_C$ is substantially zero;
- a second voltage comparator able to determine that the voltage $V_C$ is substantially equal to a maximum voltage value $V_{C\_Max}$ stored in the memory.

13. The system according to one of claims 10 to 12, wherein the power storage element is a supercapacitor.

14. An assembly comprising:

- the system for measuring the SoC according to one of claims 10 to 13;
- an electrochemical element coupled with the system for measuring the SoC.

15. The assembly according to claim 14, wherein
the electrochemical element is that of a battery comprising one or more electrochemical elements.

16. The assembly according to claim 15, wherein the battery comprises two or more branches, each branch comprising one or several electrochemical elements and being coupled with a system for measuring the SoC.

[Fig. 1]

[Fig. 2]

[Fig. 3]

SOC calculées

100%

0%

Tension SCAP

Vmax
(≈3V)

0v

Temps

Batterie en charge à courant constant ($I_{ch}$)

Batterie en décharge à courant constant ($I_{déch} ≈ 2*I_{ch}$)

☐ Polarité normale SCAP
☐ Polarité inversée SCAP

Exemple de batterie en charge/décharge où $Q_{batt} = 10*Q_{scap}$, batterie initialement déchargée

[Fig. 4]

Début
400

ACCUEIL

Condition :
Valeur de la capacité SuperCap << Valeur
de la capacité de la batterie

NON ← Limite supérieure ou inférieure atteinte à travers SuperCap → OUI

VERS ACCUEIL

410

Inverser la polarité SupCap en utilisant le H-bridge
412

NON ← Le courant de la batterie est-il positif ? → OUI
430

Calculer la nouvelle capacité = ancienne capacité - capacité SuperCap
432

Calculer la nouvelle capacité = ancienne capacité + capacité SuperCap
434

Enregistrer l'ancienne capacité = nouvelle capacité
440

Calculer la nouvelle valeur du SOC :

$SOC(\%) = 100^* $ nouvelle capacité/ capacité donnée
450

Si Vbatt = Vmin
460

Enregistrer ancienne capacité = 0
462

Le but de ces opérations est de capturer un état de batterie connu (vide ou plein)

Si Vbatt = Vmax
470

Enregistrer ancienne capacité = capacité donnée
472

VERS ACCUEIL

24

[Fig. 5]

[Fig. 6]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2269954 A
- US 20160211679 A1
- DE 102012206893 A1
- EP 3182552 A1
- EP 2144075 A
- EP 2239826 A
- EP 2309615 A